(19) Europäisches Patentamt
European Patent Office
Office européen des brevets

(11) EP 2 496 617 B1

(12) **EUROPÄISCHE PATENTSCHRIFT**

(45) Veröffentlichungstag und Bekanntmachung des Hinweises auf die Patenterteilung:
**25.02.2015 Patentblatt 2015/09**

(21) Anmeldenummer: **10771761.3**

(22) Anmeldetag: **02.11.2010**

(51) Int Cl.:
***C08G 18/28*** (2006.01) ***C08G 18/67*** (2006.01)
***C08G 18/81*** (2006.01) ***C08L 75/16*** (2006.01)
***C08F 290/06*** (2006.01) ***C08F 299/06*** (2006.01)
***G03C 1/06*** (2006.01) ***G03F 7/00*** (2006.01)
***G11B 7/245*** (2006.01) ***G11B 7/24*** (2013.01)

(86) Internationale Anmeldenummer:
**PCT/EP2010/066596**

(87) Internationale Veröffentlichungsnummer:
**WO 2011/054799 (12.05.2011 Gazette 2011/19)**

(54) **URETHANE ALS ADDITIVE IN EINER PHOTOPOLYMER-FORMULIERUNG**
URETHANES USED AS ADDITIVES IN A PHOTOPOLYMER FORMULATION
URÉTHANES UTILISÉS COMME ADDITIFS DANS UNE FORMULATION PHOTOPOLYMÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2009 EP 09013767**

(43) Veröffentlichungstag der Anmeldung:
**12.09.2012 Patentblatt 2012/37**

(73) Patentinhaber: **Bayer Intellectual Property GmbH
40789 Monheim (DE)**

(72) Erfinder:
- **RÖLLE, Thomas
51381 Leverkusen (DE)**
- **BRUDER, Friedrich-Karl
47802 Krefeld (DE)**
- **FÄCKE, Thomas
51375 Leverkusen (DE)**
- **WEISER, Marc-Stephan
51379 Leverkusen (DE)**
- **HÖNEL, Dennis
53909 Zülpich-Wichterich (DE)**

(74) Vertreter: **BIP Patents
c/o Bayer Intellectual Property GmbH
Creative Campus Monheim
Alfred-Nobel-Straße 10
40789 Monheim (DE)**

(56) Entgegenhaltungen:
**EP-A2- 1 403 709**
**WO-A1-2008/125202**
**WO-A1-2008/125229**
**US-A- 5 415 972**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 496 617 B1

## Beschreibung

Die Erfindung betrifft eine Photopolymer-Formulierung umfassend Matrixpolymere, Schreibmomomere und Photoinitiatoren, ein Verfahren zur Herstellung der Photopolymer-Formulierung, eine nach dem Verfahren erhältliche Photopolymer-Formulierung, eine Folie, einen Film, eine Schicht, einen Schichtaufbau oder einen Formkörper aus der Photopolymer-Formulierung sowie die Verwendung der Photopolymer-Formulierung zur Herstellung von optischen Elementen, insbesondere zur Herstellung von holographischen Elementen und Bildern.

In der WO 2008/125229 A1 sind Photopolymer-Formulierungen der eingangs genannten Art beschrieben. Diese umfassen Polyurethan-basierte Matrixpolymere, Schreibmomomere auf Acrylbasis sowie Photoinitiatoren. Im ausgehärtetem Zustand sind in der Polyurethanmatrix die Schreibmonomere und die Photoinitiatoren räumlich verteilt eingebettet. Aus der WO-Schrift ist ebenfalls bekannt Dibutylphthalat, einen klassischen Weichmacher für technische Kunststoffe, der Photopolymer-Formulierung hinzuzufügen.

Für die Verwendungen von Photopolymer-Formulierungen in den unten beschriebenen Anwendungs-feldem spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebenen Wellen) durch die lokale Photopolymerisation von z.B. hochbrechenden Acrylaten an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz genannt, im folgenden DE wie Diffraction Efficiency. Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die notwendige Lichtmenge des Referenzlichtes die notwendig ist um das Signal mit einer festen Helligkeit sichtbar zu machen. Hochbrechende Acrylate sind in der Lage, Brechungsindexgitter mit hoher Amplitude zwischen Bereichen mit niedrigstem Brechungsindex und Bereichen mit höchstem Brechungsindex zu erzeugen und damit in Photopolymer-Formulierungen Hologramme mit hohem DE und hohem $\Delta n$ zu ermöglichen. Dabei ist zu beachten das DE vom Produkt aus $\Delta n$ und der Photopolymerschichtdicke d abhängt. Je größer das Produkt desto größer die mögliche DE (für Reflexionshologramme). Der Breite des Winkelbereiches bei dem das Hologramm z.B. bei monochromatischer Beleuchtung sichtbar wird (rekonstruiert) hängt nur von der Schichtdicke d ab. Bei Beleuchtung der Hologramms mit z.B. weißem Licht hängt die Breite des spektralen Bereiches der zur Rekonstruktion des Hologramms beitragen kann ebenfalls nur von der Schichtdicke d ab. Dabei gilt je kleiner d desto größer die jeweiligen Akzeptanzbreiten. Will man daher helle und leicht sichtbare Hologramme herstellen ist ein hohes $\Delta n \cdot d$ und eine geringe Dicke d anzustreben und zwar so das DE möglichst groB wird. Das heißt je höher $\Delta n$ wird, desto mehr Freiraum zur Gestaltung heller Hologramme durch Anpassen von d und ohne Verlust an DE erreicht man. Daher kommt der Optimierung von $\Delta n$ bei der Optimierung von Photopolymerformulierungen eine herausragenden Bedeutung zu (Ref. Hariharan Optical Holography).

Aufgabe der vorliegenden Erfindung war es eine Photopolymer-Formulierung bereit zu stellen, die im Vergleich mit den bekannten Formulierungen die Herstellung von Hologrammen mit höherer Helligkeit ermöglicht.

Diese Aufgabe wird bei der erfindungsgemäßen Photopolymer-Formulierung dadurch gelöst, dass sie als Weichmacher Urethane enthält die es Molekular gewicht $\leq$ 250 g/mol aufweisen. So wurde gefunden, dass das Hinzufügen von Urethanen zu den bekannten Photopolymer-Formulierungen bei den hieraus hergestellten Hologrammen zu hoben $\Delta n$-Werten führt. Im Ergebnis bedeutet dies, dass die aus der erfindungsgemäßen Formulierung hergestellten Hologramme eine im Vergleich zu den bekannten Hologrammen höhere Helligkeit aufweisen.

Gemäß einer ersten Ausführungsform sind die Matrixpolymere Polyurethane. Vorzugsweise sind die Polyurethane durch Umsetzung einer Isocyanatkomponente a) mit einer Isocyanat-reaktiven Komponente b) erhältlich.

Die Isocyanatkomponente a) umfasst bevorzugt Polyisocyanate. Als Polyisocyanate können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandiisocyanat 1,4Cyclohexylendiisocyanat, die isomeren Cyclohexandimethylendiisocyanate, 1,4-Phenylendiisocyanat, 2,4- und/oder 2,6-Totuylendiisocyanat, 1,5-Naphthylendiisocyanat, 2,4'- oder 4,4'-Di-phenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-,

Carbodiimid-, Acylharnstoff-, Isocyanurat-, Allophanat-, Biuret-, Oxadiazintrion-, Uretdion-und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-oktan, Isocyanatomethyl-1,8-octandiisocyanat (TIN), 2,4- und/oder 2,6-Toluen-diisocyanat.

Als isocyanatreaktive Verbindungen a2) zum Aufbau der Prepolymere werden bevorzugt OH- funktionelle Verbindungen eingesetzt. Diese sind analog den OH-funktionellen Verbindungen wie sie nachfolgend für die Komponente b) beschrieben sind.

Ebenfalls möglich ist der Einsatz von Aminen zur Prepolymerherstellung. Beilspielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Bevorzugte Präpolymere sind Urethane, Allophanate oder Biurete aus aliphatischen Isocyanat-funktionellen Verbindungen und oligomeren oder polymeien Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol und ganz besonders bevorzugt sind Allophanate aus HDI oder TMDI und difunktionellen Polyetherpolyolen mit zahlenmittleren Molmassen von 1000 bis 8200 g/Mol.

Bevorzugt weisen die vorstehend beschriebenen Präpolymere Restgehalte an freiem monomeren Isocyanat von weniger als 1 Gew.-%, besonders bevorzugt weniger als 0,5 Gew.-%, ganz besonders bevorzugt weniger als 0,2 Gew.-% auf.

Selbstverständlich kann die Isocyanatkomponente anteilsmäßig neben den beschriebenen Präpolymeren weitere Isocyanatkomponenten enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate, eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylen-diisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4''-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilsweise mit isocyanat-reaktiven ethylenisch ungesättigten Verbindungen umgesetzt sind. Bevorzugt werden hierbei

als isocyanat-reaktives ethylenisch ungesattigten Verbindungen α,β-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)acrylate, Polyalkylenoxidmono(meth)acrylate, Poly(ε-caprolacton)mono(meth)acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, D i- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylalgruppen enthaltende Verbindungen alleine oder in Kombination mit den vorgenannten monomeren Verbindungen geeignet. Der Anteil an Isocyanaten die teilweise mit isocyanat-reaktiven ethylenisch ungesättigten Verbindungen umgesetzt sind an der Isocyanatkomponente a) beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungs-technologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls mög-lich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blöckweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alkylenoxidanteil nicht höher als 80 Gew.-% ist. Daneben sind Po-ly(trimethylenoxid)e sowie Mischungen der als bevorzugt genannten Polyole bevorzugt. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylenumfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1.

Daneben sind als Bestandteile der Komponente c) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Komponente c) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxide, Phenylglyoxylsäureester, Campherchinon, alpha-Aminoalkylphenone, alpha-,alpha--Dialkoxyacetophenone, 1-[4-(Phenylthio)phenyl]octan-1,2-dion-2-(O-benzoyloxim) und alpha-Hydroxyalkylphenone. Auch die in EP-A 0223587 beschriebenen Photoinitiatorsysteme bestehend aus einer Mischung aus einem Ammoniumarylalkylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat, Tetramethylammonium Triphenylbenzylborat, Tetra(n-hexyl)ammonium (sec-Butyl)triphenylborat, 1-Methyl-3-octylimidazolium Dipentyldiphenylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind Chrom-Salze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152). Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisarion verwendeten Photoinitiatoren bestehen im wesentlichen aus drei Kassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven

aber recht teuren $SbF_6^-$, $AsF_6^-$ oder $PF_6^-$. Für den Einsatz in Beschichtung dünner Filme sind diese Verbindungen i.d.R wenig geeignet, da die den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalanion, welches sich durch H-Abstraktion stabilisiert und ein Proton freisetzt und dann die kationische Polymerisation startet (Dektar et al. J. Org. Chem. 1990, 55, 639; J. Org. Chem., 1991, 56. 1838). Dieser Mechanimus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls recht teuren $SbF_6^-$, $AsF_6^-$ oder $PF_6^-$. Ansonsten in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die in nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivate (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Tech-nology, London, S. 61 - 328 beschrieben.

Bevorzugte Photoinitiatoren c) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

In Photopolymer-Formulierungen sind mit hochbrechenden Acrylaten als kontrastgebenden Komponenten sehr gute Ergebnisse erzielbar, wie dies bespielsweise in der US 6,780,546 beschrieben ist. Es ist daher erfindungsgemäß bevorzugt, wenn in der Photopolymer-Formulierung die Schreibmomomere Acrylate, insbesondere Urethanacrylate sind. Insbesondere bevorzugt sind aromatische Urethanacrylate mit einem Brechungsindex von $n_D^{20} > 1.5000$ bei 589 nm, wie sie beispielsweise in WO2008125199A1 beschrieben sind.

Die Erfindung sieht vor, dass die Urethane ein zahlenmittleres Molekulargewicht von ≤ 250 g/mol, bevorzugt von ≤ 200 g/mol und insbesondere bevorzugt von ≤ 190 g/mol aufweisen. So ist festgestellt worden, dass der hier beschriebene Effekt nicht mehr auftritt, wenn das Molekulargewicht > 250 g/mol ist.

Vorteilhafterweise enthält die Photopolymer-Formulierung nur aliphatische Urethane. In diesem Fall können die aliphatischen Urethane insbesondere, die die allgemeine Formel (I)

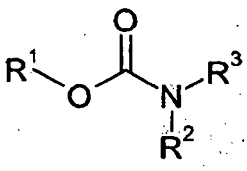

(I)

aufweisen, in der $R^1$, $R^2$, $R^3$ unabhängig voneinander lineare oder verzweigte, gegebenenfalls mit Heteroatomen substituierte, (C1-C20)-Alkyl-Reste sind. Besonders bevorzugt ist, dass $R^1$ lineare oder verzweigte (C1-C8)-Alkyl-Reste, $R^2$ lineare oder verzweigte (C1-C8)-Alkyl-Reste, und / oder $R^3$ lineare oder verzweigte (C1-C8)-Alkyl-Reste, sind, wobei insbesondere bevorzugt ist, wenn $R^1$ lineare oder verzweigte (C1-C4)-Alkyl-Reste sind, $R^2$ lineare oder verzweigte (C1-C6)-Alkyl-Reste sind und $R^3$ Wasserstoff ist. Es wurde nämlich in diesem Fall festgestellt, dass die so erhaltenen Urethane sehr gut mit der Polyurethan-Matrix verträglich sind und den hier beschriebenen Effekt zeigen.

Gemäß einer weiteren bevorzugten Ausführungsform ist vorgesehen, dass die Urethane im Wesentlichen keine freien NCO-Gruppen aufweisen.

Die erfindungswesentlichen Urethane sind durch Umsetzung von Isocyanaten der Formel (II)

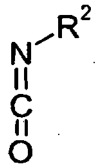

(II)

mit isocyanatreaktiven Verbindungen der Formel (III)

$R^1$-OH (III)

erhältlich, wobei die Reste die vorgenannte Bedeutung haben.

Beispiele für Verbindungen der Formel (II) sind Methylisocyanat, Ethylisocyanat, die isomeren Propylisocyanate, die isomeren Butylisocyanate, die isomeren Pentylisocyanate, die isomeren Hexylisocyanate, die isomeren Heptylisocyanate, die isomeren Octylisocyanate, die isomeren Nonylisocyanate, die isomeren Decylisocyanate, Stearylisocyanat, Cyclopropylisocyanat, Cyclobutylisocyanat, Cyclopentylisocyanat, Cyclohexylisocyanat, Cycloheptylisocyanat oder deren Mischungen.

Bevorzugt sind Methylisocyanat, Ethylisocyanat, die isomeren Propylisocyanate, die isomeren Butylisocyanate, die isomeren Pentylisocyanate, die isomeren Hexylisocyanate, die isomeren Heptylisocyanate, die isomeren Octylisocyanate oder deren Mischungen.

Besonders bevorzugt sind n-Butylisocyanat, n-Hexylisocyanat oder deren Mischung.

Als Verbindungen der Formel (III) können beispielsweise Methanol, Ethanol, die isomeren Propanole, die isomeren Butanole, die isomeren Pentanole, die isomeren Hexanole, die isomeren Heptanole, die isomeren Octanole, die isomeren Nonule, die isomeren Decanole, die isomeren Undecanole, die isomeren Dodecanole, die isomeren Tridecanole oder deren Gemische eingesetzt werden.

Bevorzugt sind Methanol, Ethanol, die isomeren Propanole, die isomeren Butanole, die isomeren Pentanole, die isomeren Hexanole, die isomeren Heptanole, die isomeren Octanole oder deren Gemische.

Besonders bevorzugt sind Ethanol, iso-Propanol oder deren Gemische.

Bei der Umsetzung von Verbindungen der Formel (II) mit Verbindungen der Formel (III) handelt es sich um eine Urethanisierung. Die Umsetzung von Verbindungen der Formel (II) mit Verbindungen der Formel (III) kann unter zu Hilfenahme der zur Beschleunigung von Isocyanatadditionsreaktionen bekannten Katalysatoren, wie z.B. tertiärer Amine, Zinn-, Zink-, Eisen- oder Bismuthverbindungen, insbesondere Triethylamin, 1,4-Diazabicyclo-[2,2,2]-octan, Bismuthoctoat oder Dibutylzinndilaurat erfolgen, die mit vorgelegt oder später zudosiert werden können. Die erfindungsgemäßen Urethane haben einen Gehalt an Isocyanatgruppen (M = 42) oder freien Restmonomeren von unter 0.5 Gew.-%, bevorzugt unter 0.2 Gew.-%, besonders bevorzugt unter 0.1 Gew.-% bezogen auf das Urethan. Weiterhin enthalten die Urethane Gehalte an nicht umgesetzter Komponente Verbindungen der Formel (III) von unter 1 Gew.-%, bevorzugt unter 0.5 Gew.-% und besonders bevorzugt unter 0.2 Gew.-% bezogen auf das Urethan. Bei der Herstellung der Urethane können die Verbindungen der Formel (II) und die Verbindungen der Formel (III) in einem nicht-reaktiven Lösungsmittel, beispielsweise einem aromatischen oder aliphatischen Kohlenwasserstoff oder einem aromatischen oder aliphatischen halogenierten Kohlenwasserstoff oder einem Lacklösungsmittel wie z.B. Ethylacetat oder Butylacetat oder Aceton oder Butanon oder einem Ether wie Tetrahydrofuran oder tert.-Butylmethylether oder einem dipolar-aprotischen Lösungsmittel wie Dimethylsufoxid oder N-Methylpyrrolidon oder N-Ethylpyrrolidon gelöst werden und in dem Fachmann geläufiger Weise vorgelegt oder zudosiert werden. Nach Reaktionsende werden die nicht-reaktiven Lösungsmittel unter Normaldruck oder unter reduziertem Druck aus dem Gemisch entfernt und der Endpunkt mittels Festgehaltbestimmung ermittelt. Die Festgehalte liegen typischerweise in einem Bereich von 99.999 bis 95.0 Gew.-%, bevorzugt von 99.998 bis 98.0 Gew. -% bezogen auf das Urethan.

Die erfindungsgemäße Photopolymer-Formulierung kann insbesondere 15 bis 79, bevorzugt 30 bis 60 Gew.-% Matrixpolymer, 5 bis 50, bevorzugt 10 bis 40 Gew.-% Schreibmonomer, 1 bis 10, bevorzugt 1 bis 3 Gew.-% Photoinitiator und 5 bis 50, bevorzugt 10 bis 40 Gew.-% Urethane und 0 bis 10 Gew.-% weitere Additive enthalten, wobei die Summe der Bestandteile 100 Gew.-% beträgt.

Ein zweiter Aspekt der Erfindung betrifft ein Verfahren zur Herstellung einer Photopolymer-Formulierung bei dem Matrixpolymere, Schreibmomomere, Photoinitiatoren und Urethane als Weichmacher zu der Photopolymer-Formulierung vermischt werden.

Ein dritter Aspekt der Erfindung betrifft eine nach dem Verfahren erhältliche Photopolymer-Formulierung.

Ein vierter Aspekt der Erfindung betrifft eine Folie, einen Film, eine Schicht, einen Schichtaufbau oder einen Formkörper aus der Photopolymer-Formulierung.

Schichten, Schichtaufbauten und Formkörper aus den erfindungsgemäßen Photopolymer-Formulierungen weisen typischerweise Δn-Werte, gemessen nach dem im Abschnitt "Messung der holographischen Eigenschaften DE und Δn der holographischen Medien mittels Zweistrahlinterferenz in Reflexionsanordnung" beschriebenen Verfahren, von Δn > 0.012 , bevorzugt > 0.0135, besonders bevorzugt > 0.015, ganz besonders bevorzugt > 0.0165 auf.

Ein fünfter Aspekt der Erfindung betrifft die Verwendung der Photopolymer-Formulierung zur Herstellung von optischen Elementen, insbesondere zur Herstellung von holographischen Elementen und Bildern.

Ebenfalls Gegenstand der Erfindung ist ein Verfahren zur Belichtung von holographischen Medien und holographischen Photopolymer-Filmen aus der erfindungsmäßen Photopolymer-Formulierung, bei dem die in der Matrix vorliegenden Schreibmonomere durch elektromagnetische Strahlung selektiv polymerisiert werden.

Derartige holographische Medien eignen sich nach der holographischen Belichtung zur Herstellung von holographischen optischen Elementen, die z.B. die Funktion einer optischen Linse, eines Spiegels, eines Umlenkspiegels, eines Filters, einer Streuscheibe, eines Beugungselements, eines Lichtleiters, eines Lichtlenkers, einer Projektionsscheibe und/oder einer Maske haben. Zudem können damit auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können, u.a auch in Kombination mit den zuvor dargestellten Produkten.

## Beispiele

Die Erfindung wird im Folgenden anhand von Beispielen näher erläutert.

Sofern nicht abweichend vermerkt beziehen sich alle Prozentangaben auf Gewichtsprozent.

Die Messung des Brechungsindex $n_D^{20}$ erfolgte bei einer Wellenlänge von 589 nm und einer Temperatur von 20 °C mit einem Spektrometer der Firma Steag ETA Optics (Modell ETA - RT).

Die angegebenen NCO-Werte (Isocyanat-Gehalte) wurden gemäß DIN EN ISO 11909 bestimmt.

Die in den Vergleichsmedien eingesetzten kommerziellen Weichmacher wurden im Chemikalien-Handel bezogen (Adipinsäuredimethylester von Merck/Darmstadt, Diethylglykoldiacetat von ABCR, Propylencarbonat von Fluka, Zitronensäuretriethylester von Sigma-Aldrich)

CGI-909 (Tetrabutylammonium-tris(3-chlor-4-methylphenyl)(hexyl)borat, [1147315-11-4]) ist ein von der Fa. CIBA Inc., Basel, Schweiz, hergestelltes Versuchsprodukt.

### Beispiel 1: Ethyl-hexylcarbamat

In einem 250 mL Rundkolben wurden 0.02 g Desmorapid Z (Dibutylzinndilaurat, Bayer MaterialScience AG, Leverkusen, Deutschland), 36.7 g n-Hexylisocyanat vorgelegt und auf 60 °C erwärmt. Anschließend wurden 13.3 g Ethanol zugetropft und die Mischung weiter auf 60 °C gehalten, bis der Isocyanatgehalt unter 0.1 % gesunken war. Danach wurde abgekühlt und das Produkt wurde als klare Flüssigkeit erhalten.

### Beispiel 2: iso-Propyl-hexylcarbamat

In einem 250 mL Rundkolben wurden 0.02 g Desmorapid Z, 34.0 g n-Hexylisocyänat vorgelegt und auf 60 °C erwärmt. Anschließend wurden 16.0 g iso-Propanol zugetropft und die Mischung weiter auf 60 °C gehalten, bis der Isocyanatgehalt unter 0.1 % gesunken war. Danach wurde abgekühlt und das Produkt wurde als klare Flüssigkeit erhalten.

### Beispiel 3: Ethyl-butylcarbamat

In einem 250 mL Rundkolben wurden 0.02 g Desmorapid Z, 34.1 g n-Butylisocyanat vorgelegt und auf 60 °C erwärmt. Anschließend wurden 15.9 g Ethanol zugetropft und die Mischung weiter auf 60 °C gehalten, bis der Isocyanatgehalt unter 0.1 % gesunken war. Danach wurde abgekühlt und das Produkt wurde als klare Flüssigkeit verhalten.

### Beispiel 4: iso-Propyl-butylcarbamat

In einem 250 mL Rundkolben wurden 0.02 g Desmorapid Z, 31.1 g n-Butylisocyanat vorgelegt und auf 60 °C erwärmt. Anschließend wurden 18.9 g iso-Propanol zugetropft und die Mischung weiter auf 60 °C gehalten, bis der Isocyanatgehalt unter 0.1 % gesunken war. Danach wurde abgekühlt und das Produkt wurde als klare Flüssigkeit erhalten.

**Tabelle 1:** Charakterisierung der Beispiele 1-4 und der kommerziellen Weichmacher aus den Vergleichsbeispielen II-V

| Beispiel | Name | $n_D^{20}$ |
|---|---|---|
| 1 | Ethyl-hexylcarbamat | 1.4376 |
| 2 | iso-Propyl-Hexylcarbamat | 1.4336 |
| 3 | Ethyl-butylcarbamat | 1.4313 |
| 4 | iso-Propyl-butylcarbamat | 1.4284 |
| II | Propylencarbonat | 1.4220 |
| III | Adipinsäuredimethylester | 1.4350 |
| IV | Diethylenglycoldiacetat | 1.4310 |
| V | Zitronensäuretriethylester | 1.4423 |

Zur Prüfung der optischen Eigenschaften wurden wie im Folgenden beschrieben Medien hergestellt und optisch vermessen:

**Herstellung der Polyol-Komponente:**

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nichtflüchtigen Bestandteile) bei 99.5 Gew.-% oder darüber lag. Anschließend wurde abgekühlt und das Produkt als wachsiger Feststoff erhalten.

**Herstellung des Urethanacrylates 1:**

In einem 500 mL Rundkolben wurden 0.1 g 2,6-Di-tert.-butyl-4-methylphenol, 0.05 g Dibutylzinndilaurat (Desmorapid Z) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Abschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Medium 1:**

3.82 g der wie oben beschrieben hergestellten Polyol-Komponente wurden mit 2.50 g Urethanacrylat 1, 2.50 g Ethyl-hexylcarbamat (Beispiele 1), 0.10 g CGI 909 (Versuchsprodukt der Fa. Ciba Inc, Basel, Schweiz), 0.010 g Neu Methylenblau und 0.35 g N-Ethylpyrrolidon bei 60 °C so gemischt, dass eine klare Lösung erhalten wurde. Anschließend wurde auf 30 °C abgekühlt, 0.707 g Desmodur® N 3900 (Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.006 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 µm gehalten wurde. Dieser Probenkörper wurde 12 Stunden bei Raumtemperatur liegen gelassen und gehärtet.

Die Medien 2-4 wurden in analoger Art und Weise aus den in Tabelle 1 aufgeführten Beispielen hergestellt.

**Vergleichsmedium I:**

8.89 g der wie oben beschrieben hergestellten Polyol-Komponente wurden mit 3.75 g Urethanacrylat 1, 0.15 g CGI 909 (Versuchsprodukt der Fa. Ciba Inc, Basel, Schweiz), 0.015 g Neu Methylenblau und 0.35 g N-Ethylpyrrolidon bei 60 °C so gemischt, dass eine klare Lösung erhalten wurde. Anschließend wurde auf 30 °C abgekühlt, 1.647 g Desmodur® N 3900 (Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.009 g Fomrez UL 28 (Urethanisierungskatalysator, Handelsprodukt der Fa.

Momentive Performance Chemicals, Wilton, CT, USA) zugegeben und erneut kurz gemischt. Die erhaltene,

flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

**Vergleichsmedium II:**

3.82 g der wie oben beschrieben hergestellten Polyol-Komponente wurden mit 2.50 g Urethanacrylat 1, 2.50 g Propylencarbonat (Vergleichsbeispiel II), 0.10 g CGI 909 (Versuchsprodukt der Fa. Ciba Inc, Basel, Schweiz), 0.010 g Neu Methylenblau und 0.35 g N-Ethylpyrrolidon bei 60 °C so gemischt, dass eine klare Lösung erhalten wurde. Anschließend wurde auf 30 °C abgekühlt, 0.702 g Desmodur® N 3900 (Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.022 g Fomrez UL 28 (U-rethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde 12 Stunden bei Raumtemperatur liegen gelassen und gehärtet.

Die Vergleichsmedien III-V wurden in analoger Art und Weise aus den in Tabelle 1 aufgeführten Vergleichsbeispielen hergestellt.

**Messung der holographischen Eigenschaften DE und Δn der holographischen Medien mittels Zweistrahlinterferenz in Reflexionsanordnung**

Die wie im Abschnitt "Herstellung der holographischen Medien basierend auf Photopolymer-Formulierung mit Photoinitiatator zur Bestimmung der Performance Parameter DE und Δn" beschrieben hergestellten Medien wurden anschließend mittels einer Messanordnung gemäß Figur 1 wie folgt auf ihre holographischen Eigenschaften geprüft:

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahl beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen).

Figur 1 zeigt den holographischen Versuchsaufbau, mit dem die Beugungseffizienz (DE) der Medien gemessen wurde. Figur 1 zeigt die Geometrie eines HMT bei λ = 633 nm (He-Ne Laser): M = Spiegel, S = Verschluss, SF = Raumfilter, CL = Kollimatorlinse, λ/2 = λ/2 Platte, PBS = polarisations-empfindlicher Strahlteiler, D = Detektor, I = Irisblende, α = 21.8°, β = 41.8° sind die Einfallswinkel der kohärenten Strahlen ausserhalb der Probe (des Mediums) gemessen.

Es wurden auf folgende Weise Hologramme in das Medium geschrieben:

- Beide Shutter (S) sind für die Belichtungszeit t geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man das für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel Ω wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen der Drehwinkel $\Omega$ aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelver-lauf der transmittierten Intensität ermittelt. Das Verfahren wird im Folgenden beschrieben:

Für die Braggkurve $\eta(\Omega)$ eines Reflexionshologramms gilt nach Kogelnik:

$$\eta = \frac{1}{1 + \frac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha), n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\psi$ der Kippwinkel des Brechungsindexgitters das geschrieben

wurde. $\alpha'$ und $\beta'$ entsprechen den Winkeln $\alpha$ und $\beta$ beim Schreiben des Hologramms, aber im Medium gemessen. $\Delta\theta$ ist das Winkeldetuning gemessen im Medium, also die Abweichung vom Winkel $\alpha'$. $\Delta\Omega$ ist das Winkeldetuning gemessen ausserhalb des Mediums, also die Abweichung vom Winkel $\alpha$. n ist der mittlere Brechungsindex des Photopolymers und wurde zu 1.504 gesetzt. $\lambda$ ist die Wellenlänge des Laserlichts im Vakuum.

Die maximale Beugungseffzienz (DE = $\eta_{max}$) ergibt sich dann für $\chi$ = 0, also $\Delta\Omega$ = 0 zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

Die Messdaten der Beugungseffizienz, die theoretische Braggkurve und die transmittierte Intensität werden wie in Figur 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta$n wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Windelbereich erfassen kann, wird die Braggkurve von breiten Holgrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2 zeigt die Darstellung der Braggkurve $\eta$ nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt aus den Leistungen der zwei den Winkeln $\alpha$ und $\beta$ zugeordneten Teilstrahlen ($P_\alpha$ = 0.50 mW und $P_\beta$ = 0.67 mW), der Belichtungszeit t und dem Durchmesser der Irisblende (0.4 cm):

$$E\,(\mathrm{mJ/cm^2}) = \frac{2 \cdot \left[P_\alpha + P_\beta\right] \cdot t\,(\mathrm{s})}{\pi \cdot 0.4^2\ \mathrm{cm}^2}$$

Die Leistungen der Teilstrahlen wurden so angepasst, dass in dem Medium bei den verwendeten Winkeln $\alpha$ und $\beta$, die gleiche Leistungsdichte erreicht wird.

Dabei ergaben sich folgende Messwerte für DE [%] und $\Delta$n bei der Dosis E [mJ/cm$^2$]:

**Tabelle 2:** Holographische Bewertung ausgewählter Beispiele

| Medium | Beispiele [Gew.-%] | $\Delta$n | DE [%] | Dosis E [mJ/cm$^2$] |
|---|---|---|---|---|
| 1 | Ethyl-hexylcarbamat, 25 | 0.0172 | 94 | 9 |
| 2 | iso-Propyl-hexylcarbamat, 25 | 0.0174 | 97 | 9 |
| 3 | Ethyl-butylcarbamat, 25 | 0.0167 | 87 | 9 |
| 4 | iso-Propyl-butylcarbamat, 25 | 0.0176 | 93 | 9 |

(fortgesetzt)

| | Vergleichsbeispiele, [Gew.-%] | Δn | DE [%] | Dosis E [mJ/cm$^2$] |
|---|---|---|---|---|
| I | Kein Additiv | 0.0115 | 89 | 9 |
| II | Propylencarbonat, 25 | 0.0136 | 87 | 36 |
| III | Adipinsäuredimethylester, 25 | 0.0146 | 88 | 36 |
| IV | Diethylenglycoldiacetat, 25 | 0.0146 | 93 | 18 |
| V | Zitronensäuretriethylester, 25 | 0.0115 | 78 | 72 |

Die gefundenen Werte für die holographischen Eigenschaften Dynamischer Bereich (DE) und Δn der holographischen Medien zeigen, dass die in den Vergleichsmedium verwendeten kommerziellen Additive für die Verwendung in holographischen Medien weniger geeignet sind, wohingegen die erfindungsgemäßen Urethane in den Medien 1 bis 4 für die Herstellung holographischer Medien aufgrund der hohen Werte für DE und der höheren Wertes für Δn sehr gut geeignet sind. Zudem ist aus der Auftragung in Figur 2 ersichtlich, dass die hier gefundenen Urethanacrylate trotz ihres höheren Brechungsindex zu besserer holographischer Performance führen.

## Patentansprüche

1. Photopolymer-Formulierung umfassend Matrixpolymere, Schreibmomomere und Photoinitiatoren, **dadurch gekennzeichnet, dass** sie als Weichmacher Urethane enthält, die ein Molekulargewicht ≤ 250 g/mol aufweisen.

2. Photopolymer-Formulierung nach Anspruch 1, **dadurch gekennzeichnet, dass** die Matrixpolymere Polyurethane sind.

3. Photopolymer-Formulierung nach Anspruch 2, **dadurch gekennzeichnet, dass** die Polyurethane durch Umsetzung von einer Isocyanat- und einer Isocyanat-reaktiven Komponente erhältlich sind.

4. Photopolymer-Formulierung nach einem der Ansprüche 1 bis 3, **dadurch gekennzeichnet, dass** die Schreibmomomere Acrylate, bevorzugt Urethanacrylate sind.

5. Photopolymer-Formulierung nach einem der Ansprüche 1 bis 4, **dadurch gekennzeichnet, dass** die Urethane ein Molekulargewicht von ≤ 200 g/mol und bevorzugt von ≤ 190 g/mol aufweisen.

6. Photopolymer-Formulierung nach einem der Ansprüche 1 bis 5, **dadurch gekennzeichnet, dass** sie nur aliphatische Urethane enthält.

7. Photopolymer-Formulierung nach Anspruch 6, **dadurch gekennzeichnet, dass** die aliphatischen Urethane die allgemeine Formel (I)

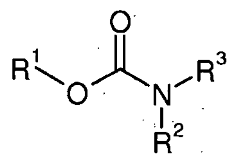

(I)

aufweisen, in der $R^1$, $R^2$, $R^3$ unabhängig voneinander lineare oder verzweigte, gegebenenfalls mit Heteroatomen substituierte, $(C_1-C_{20})$-Alkyl-Reste sind.

8. Photopolymer-Formulierung nach Anspruch 7, **dadurch gekennzeichnet, dass** $R^1$, $R^2$, $R^3$ unabhängig voneinander lineare oder verzweigte, gegebenenfalls mit Heteroatomen substituierte, (C1-C20)-Alkyl-Reste sind, wobei bevorzugt $R^1$ ein linearer oder verzweigter (C1-C8)-Alkyl-Rest, $R^2$ ein linearer oder verzweigter (C1-C8)-Alkyl-Rest, und

/ oder $R^3$ ein linearer oder verzweigter (C1-C8)-Alkyl-Rest, und besonders bevorzugt $R^1$ ein linearer oder verzweigter (C1-C4)-Alkyl-Rest, $R^2$ ein linearer oder verzweigter (C1-C6)-Alkyl-Rest und / oder $R^3$ Wasserstoff sind.

**9.** Photopolymer-Formulierung nach einem der Ansprüche 1 bis 8, **dadurch gekennzeichnet, dass** die Urethane im Wesentlichen keine freien NCO-Gruppen aufweisen.

**10.** Photopolymer-Formulierung nach einem der Ansprüche 1 bis 9, **dadurch gekennzeichnet, dass** sie 15 bis 79, bevorzugt 30 bis 60 Gew.-% Matrixpolymere, 5 bis 50, bevorzugt 10 bis 40 Gew.-% Schreibmonomere, 1 bis 10, bevorzugt 1 bis 3 Gew.-% Photoinitiatoren und 5 bis 50, bevorzugt 10 bis 40 Gew.-% Urethane und 0 bis 10 Gew.-% weitere Additive enthält, wobei die Summe der Bestandteile 100 Gew.-% beträgt.

**11.** Verfahren zur Herstellung einer Photopolymer-Formulierung gemäß einem der Ansprüche 1 bis 10, **dadurch gekennzeichnet, dass** Matrixpolymere, Schreibmomomere, Photoinitiatoren und Urethane als Weichmacher zu der Photopolymer-Formulierung vermischt werden.

**12.** Photopolymer-Formulierung erhältlich nach dem Verfahren des Anspruchs 11.

**13.** Folie, Film, Schicht, Schichtaufbau oder Formkörper aus einer Photopolymer-Formulierung gemäß einem der Ansprüche 1 bis 10 oder 12.

**14.** Verwendung einer Photopolymer-Formulierung nach einem der Ansprüche 1 bis 10 oder 12 zur Herstellung von optischen Elementen, insbesondere zur Herstellung von holographischen Elementen und Bildern.

## Claims

**1.** Photopolymer formulation comprising matrix polymers, writing monomers and photoinitiators, **characterized in that** it contains urethanes having a molecular weight of ≤ 250 g/mol as plasticizers.

**2.** Photopolymer formulation according to Claim 1, **characterized in that** the matrix polymers are polyurethanes.

**3.** Photopolymer formulation according to Claim 2, **characterized in that** the polyurethanes are obtainable by reacting an isocyanate component and an isocyanate-reactive component.

**4.** Photopolymer formulation according to any of Claims 1 to 3, **characterized in that** the writing monomers are acrylates, preferably urethane acrylates.

**5.** Photopolymer formulation according to any of Claims 1 to 4, **characterized in that** the urethanes have a molecular weight of ≤ 200 g/mol and preferably of ≤ 190 g/mol.

**6.** Photopolymer formulation according to any of Claims 1 to 5, **characterized in that** it contains only aliphatic urethanes.

**7.** Photopolymer formulation according to Claim 6, **characterized in that** the aliphatic urethanes have the general formula (I)

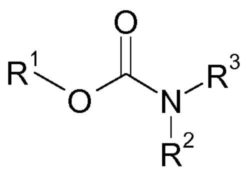

(I)

in which $R^1$, $R^2$, $R^3$, independently of one another, are linear or branched ($C_1$-$C_{20}$)-alkyl radicals optionally substituted by heteroatoms.

**8.** Photopolymer formulation according to Claim 7, **characterized in that** $R^1$, $R^2$, $R^3$, independently of one another, are linear or branched (C1-C20)-alkyl radicals optionally substituted by heteroatoms, preferably $R^1$ being a linear

or branched (C1-C8)-alkyl radical, $R^2$ being a linear or branched (C1-C8)-alkyl radical and/or $R^3$ being a linear or branched (C1-C8)-alkyl radical, and particularly preferably $R^1$ being a linear or branched (C1-C4)-alkyl radical, $R^2$ being a linear or branched (C1-C6)-alkyl radical and/or $R^3$ being hydrogen.

**9.** Photopolymer formulation according to any of Claims 1 to 8, **characterized in that** the urethanes have substantially no free NCO groups.

**10.** Photopolymer formulation according to any of Claims 1 to 9, **characterized in that** it contains 15 to 79, preferably 30 to 60, % by weight of matrix polymers, 5 to 50, preferably 10 to 40, % by weight of writing monomers, 1 to 10, preferably 1 to 3, % by weight of photoinitiators and 5 to 50, preferably 10 to 40, % by weight of urethanes and 0 to 10% by weight of further additives, the sum of the constituents being 100% by weight.

**11.** Process for the preparation of a photopolymer formulation according to any of Claims 1 to 10, **characterized in that** the matrix polymers, writing monomers, photoinitiators and urethanes as plasticizers are mixed to give the photopolymer formulation.

**12.** Photopolymer formulation obtainable by the process of Claim 11.

**13.** Sheet, film, layer, layer structure or moulding comprising a photopolymer formulation according to any of Claims 1 to 10 or 12.

**14.** Use of a photopolymer formulation according to any of Claims 1 to 10 or 12 for the production of optical elements, in particular for the production of holographic elements and images.

## Revendications

**1.** Formulation de photopolymère comprenant des polymères de matrice, des monomères d'enregistrement et des photo-initiateurs, **caractérisée en ce qu'**elle contient, comme plastifiant, des uréthanes qui présentent un poids moléculaire ≤ 250 g/mole.

**2.** Formulation de photopolymère selon la revendication 1, **caractérisée en ce que** les polymères de matrice sont des polyuréthanes.

**3.** Formulation de photopolymère selon la revendication 2, **caractérisée en ce que** les polyuréthanes peuvent être obtenus par transformation d'un composant isocyanate et d'un composant réactif avec isocyanate.

**4.** Formulation de photopolymère selon l'une quelconque des revendications 1 à 3, **caractérisée en ce que** les monomères d'enregistrement sont des acrylates, de préférence des uréthane-acrylates.

**5.** Formulation de photopolymère selon l'une quelconque des revendications 1 à 4, **caractérisée en ce que** les uréthanes présentent un poids moléculaire ≤ 200 g/mole et de préférence ≤ 190 g/mole.

**6.** Formulation de photopolymère selon l'une quelconque des revendications 1 à 5, **caractérisée en ce qu'**elle ne contient que des uréthanes aliphatiques.

**7.** Formulation de photopolymère selon la revendication 6, **caractérisée en ce que** les uréthanes aliphatiques présentent la formule générale (I)

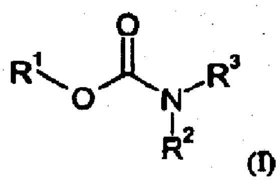

(I)

dans laquelle $R^1$, $R^2$, $R^3$ représentent, indépendamment les uns des autres, des radicaux $(C_1\text{-}C_{20})$-alkyle linéaires

ou ramifiés, le cas échéant substitués par des hétéroatomes.

**8.** Formulation de photopolymère selon la revendication 7, **caractérisée en ce que** $R^1$, $R^2$, $R^3$ représentent, indépendamment les uns des autres, des radicaux ($C_1$-$C_{20}$)-alkyle linéaires ou ramifiés, le cas échéant substitués par des hétéroatomes, $R^1$ étant de préférence un radical ($C_1$-$C_8$)-alkyle linéaire ou ramifié, $R^2$ étant de préférence un radical ($C_1$-$C_8$) - alkyle linéaire ou ramifié et/ou $R^3$ étant de préférence un radical ($C_1$-$C_8$)-alkyle linéaire ou ramifié et de manière particulièrement préférée $R^1$ étant un radical ($C_1$-$C_4$) -alkyle linéaire ou ramifié, $R^2$ étant un radical ($C_1$-$C_6$)-alkyle linéaire ou ramifié et/ou $R^3$ représentant hydrogène.

**9.** Formulation de photopolymère selon l'une quelconque des revendications 1 à 8, **caractérisée en ce que** les uréthanes ne présentent pratiquement pas de groupes NCO libres.

**10.** Formulation de photopolymère selon l'une quelconque des revendications 1 à 9, **caractérisée en ce qu'**elle contient 15 à 79, de préférence 30 à 60% en poids de polymères de matrice, 5 à 50, de préférence 10 à 40% en poids de monomères d'enregistrement, 1 à 10, de préférence 1 à 3% en poids de photo-initiateurs et 5 à 50, de préférence de 10 à 40% en poids d'uréthanes et 0 à 10% en poids d'autres additifs, la somme des constituants valant 100% en poids.

**11.** Procédé pour la préparation d'une formulation de photopolymère selon l'une quelconque des revendications 1 à 10, **caractérisé en ce que** les polymères de matrice, les monomères d'enregistrement, les photo-initiateurs et les uréthanes en tant que plastifiant sont mélangés en formulation de photopolymère.

**12.** Formulation de photopolymère pouvant être obtenue selon le procédé selon la revendication 11.

**13.** Feuille, film, couche, structure à couches ou corps façonné en une formulation de photopolymère selon l'une quelconque des revendications 1 à 10 ou 12.

**14.** Utilisation d'une formulation de photopolymère selon l'une quelconque des revendications 1 à 10 ou 12 pour la production d'éléments optiques, en particulier pour la production d'éléments et d'images holographiques.

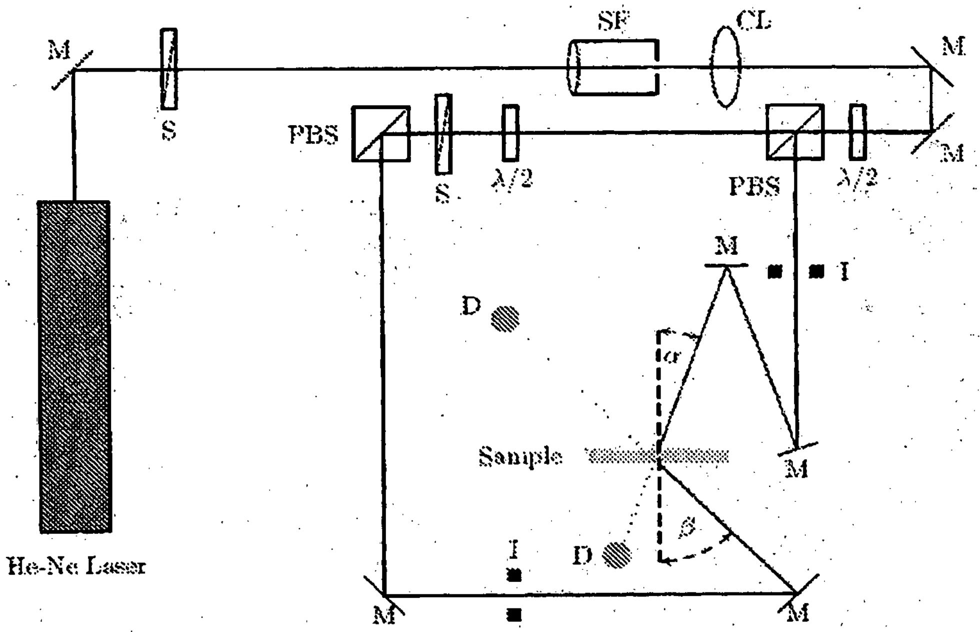


Fig. 1

Fig. 2

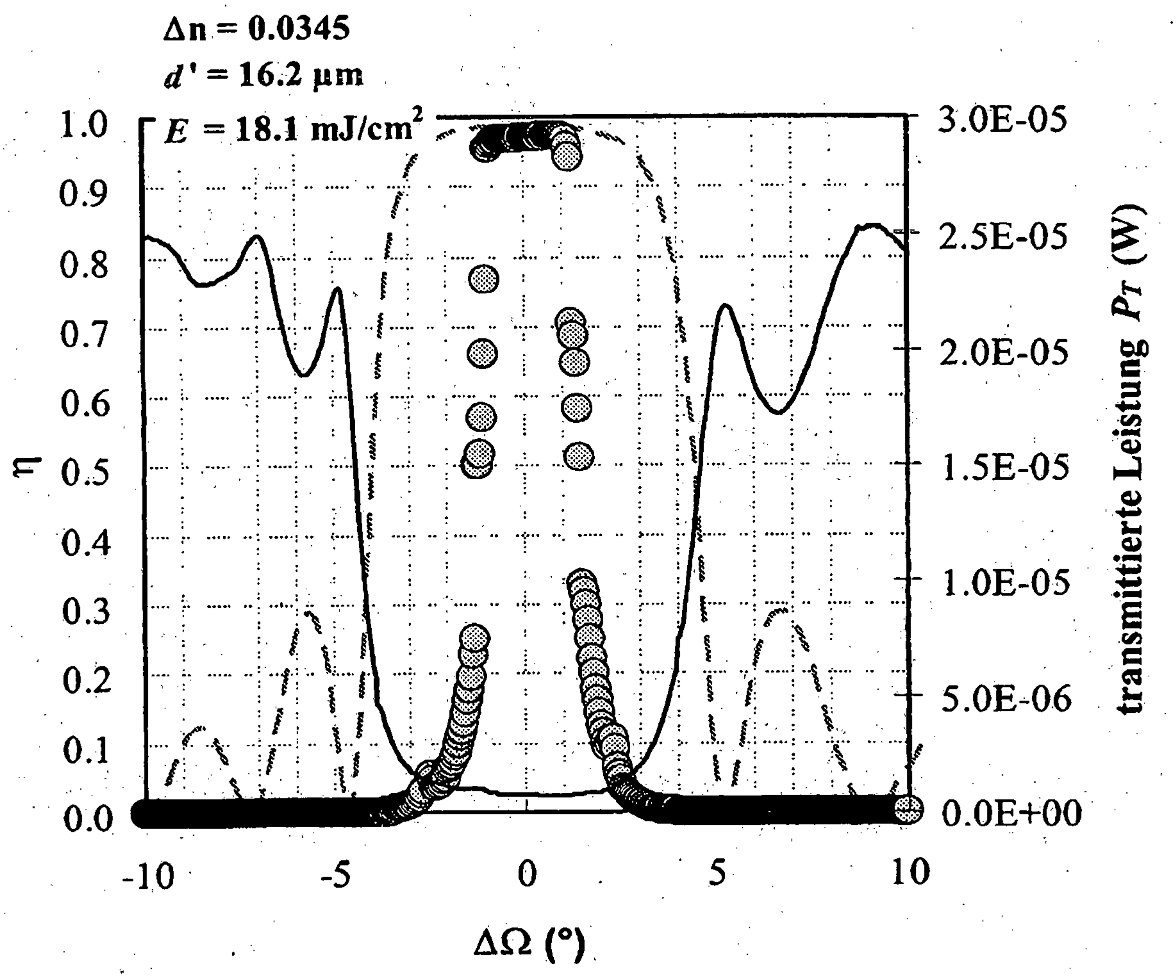
Δn = 0.0345
d' = 16.2 µm
E = 18.1 mJ/cm²
η
1.0
0.9
0.8
0.7
0.6
0.5
0.4
0.3
0.2
0.1
0.0
-10
-5
0
5
10
ΔΩ (°)
3.0E-05
2.5E-05
2.0E-05
1.5E-05
1.0E-05
5.0E-06
0.0E+00
transmittierte Leistung $P_T$ (W)

Fig. 3

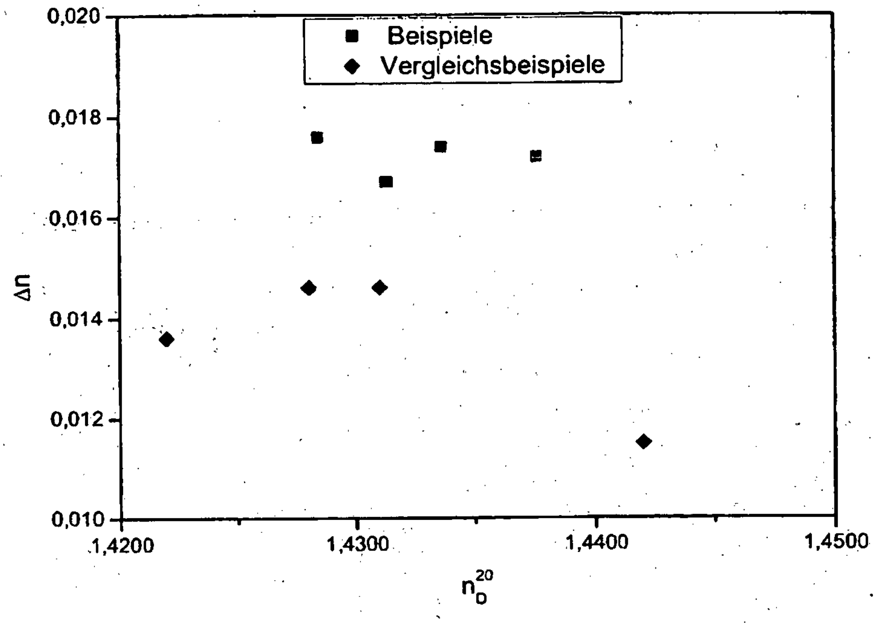


Figur 3: Gemessenes Δn der Photopolymer-Formulierungen enthaltend Beispiele ( ■ ) und Vergleichsbeispiele ( ◆ ) als Funktion des Brechungsindex $n_D^{20}$

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- EP 0223587 A
- US 6780546 B
- WO 2008125199 A1


### In der Beschreibung aufgeführte Nicht-Patentliteratur


- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings, Inks & Paints. SITA Tech-nology, 1991, vol. 3, 61-328
- **H. KOGELNIK.** *The Bell System Technical Journal,* 1969, vol. 48 (9), 2909, , 2947